# EUROPEAN PATENT SPECIFICATION

(11) **EP 3 731 259 B1**
(45) Date of publication and mention of the grant of the patent: **08.05.2024**
(21) Application number: 18923149.1
(22) Date of filing: 21.06.2018
(51) Int. Cl.: H01L 21/02, H10N 30/072

(54) **COMPOSITE MONOCRYSTALLINE FILM**
MONOKRISTALLINER VERBUNDFILM
FILM MONOCRISTALLIN COMPOSITE

(43) Date of publication of application: 28.10.2020
(73) Proprietor: Jinan Jingzheng Electronics Co., Ltd., Jinan, Shandong 250101 (CN)
(72) Inventor: ZHU, Houbin, Jinan, Shandong 250101 (CN); LI, Zhenyu, Jinan, Shandong 250101 (CN); HU, Wen, Jinan, Shandong 250101 (CN); HU, Hui, Jinan, Shandong 250101 (CN); LI, Yangyang, Jinan, Shandong 250101 (CN)
(74) Representative: Casalonga
(86) International application number: PCT/CN2018/092190
(87) International publication number: WO 2019/241960

(56) References cited:
- CN-A- 1 385 906
- CN-A- 105 321 806
- CN-A- 105 321 806
- CN-A- 107 615 449
- JP-A- 2017 139 720

## Description

### FIELD OF TECHNOLOGY

The present disclosure relates to a composite monocrystalline film.

### BACKGROUND

CN105 321 806 A discloses an example of a composite single crystal thin film and a method for manufacturing the composite single crystal thin film. The composite single crystal thin film comprises: a substrate; an optical isolation layer, which is located on the substrate; a lithium niobate single crystal thin film or a lithium tantalate single crystal thin film, which is located on the optical isolation layer; and a silicon thin film, which is located on the lithium niobate single crystal thin film or the lithium tantalate single crystal thin film.

lithium niobate or lithium tantalate monocrystalline films have excellent non-linear optical, electro-optical, and acousto-optical characteristics, and have been used widely in optical signal processing and information storage, etc. Silicon materials have become the most widely used materials in the semiconductor industry because of their excellent electrical characteristics. However, the deficiency of silicon materials in optical properties has limited their application in the optoelectronics field.

### SUMMARY

In order to solve the above-mentioned technical problems existing in the prior art, the present disclosure is intended to provide a composite monocrystalline film that combines the advantages of a lithium niobate or lithium tantalate monocrystalline film and a silicon material. The composite monocrystalline film can take advantage of both the optical characteristics of the lithium niobate or lithium tantalate monocrystalline film and the electrical characteristics of the silicon monocrystalline film to provide a device with excellent performance. The composite monocrystalline film can be produced stably and effectively in industry, and has a very broad application prospect.

According to the present disclosure, a composite monocrystalline film is defined in claim 1. Embodiments of the present disclosure are defined in the dependent claims.

According to an embodiment of the present disclosure, the composite monocrystalline film may further include a second isolation layer interposed between the first film layer and the second film layer, and each of the first isolation layer and second isolation layer may be a silicon dioxide layer or silicon nitride layer and has a thickness of 0.005 µm to 4 µm.

According to an embodiment of the present disclosure, each of the first transition layer, second transition layer and third transition layer may have a concentration of Ar ranging from 1 × 10²⁰ to 1 × 10²³ atoms/cc.

According to an embodiment of the present disclosure, the concentration of H in the second transition layer may be higher than that in the first isolation layer and that in the first film layer, and the concentration of H in the third transition layer may be higher than that in the first film layer and that in the second film layer.

According to an embodiment of the present disclosure, the first transition layer may have a thickness of 0.5 to 15 nm, the second transition layer may have a thickness of 0.5 to 10 nm, and the third transition layer may have a thickness of 0.5 to 15 nm.

According to an embodiment of the present disclosure, the third transition layer may include a first sub-transition layer adjacent to the first film layer and a second sub-transition layer adjacent to the second film layer. In the first sub-transition layer, the concentration of an element from the first film layer may be higher than the concentration of an element from the second film layer, and the concentration of an element from the first film layer may gradually decrease from the first sub-transition layer toward the second sub-transition layer. In the second sub-transition layer, the concentration of an element from the second film layer may be higher than the concentration of an element from the first film layer, and the concentration of an element from the second film layer may gradually decrease from the second sub-transition layer toward the first sub-transition layer.

According to an embodiment of the present disclosure, each of the first film layer and second film layer may be a monocrystalline film which has a nano-scale thickness of 10 to 2000 nm.

According to the present disclosure, the first film layer is a lithium niobate monocrystalline film or lithium tantalate monocrystalline film, and the second film layer is a silicon monocrystalline film.

According to an embodiment of the present disclosure, the third transition layer may include: Si, which is distributed across the third transition layer, wherein the concentration of Si gradually decreases from the silicon monocrystalline film layer to the lithium niobate or lithium tantalate monocrystalline film layer; and Ta or Nb, which is not distributed across the third transition layer, wherein the concentration of Ta or Nb gradually decreases from the lithium niobate or lithium tantalate monocrystalline film layer to the silicon monocrystalline film layer.

According to an embodiment of the present disclosure, the substrate may be a silicon substrate, lithium niobate substrate, or lithium tantalate substrate, and the substrate may have a thickness of 0.1 to 1 mm.

### BRIEF DESCRIPTION OF THE DRAWINGS

These and/or other aspects will become clearer and easier to understand through the following description of the embodiments in conjunction with the accompanying drawings, in which:
FIG. 1 shows a schematic diagram illustrating the structure of a composite monocrystalline film according to an embodiment of the present disclosure;
FIG. 2 illustrates a transmission electron microscope (TEM) image of a composite monocrystalline film according to an embodiment of the present disclosure;
FIG. 3 shows an enlarged view of the area A shown in FIG. 2;
FIG. 4 shows an element distribution diagram of the area A shown in FIG. 2;
FIG. 5 shows an enlarged view of the area B shown in FIG. 2;
FIG. 6 shows an element distribution diagram of the area B shown in FIG. 2;
FIG. 7 shows an enlarged view of the area C shown in FIG. 2;
FIG. 8 shows an element distribution diagram of the area C shown in FIG. 2; and
FIG. 9 illustrates a secondary ion mass spectrum (SIMS) image of areas A and B shown in FIG. 2.

### DESCRIPTION OF THE EMBODIMENTS

Embodiments of the present disclosure will now be described more fully with reference to the accompanying drawings, in which embodiments of the present disclosure are shown. This disclosure may, however, be embodied in various forms and should not be construed as limited to the embodiments set forth herein. These embodiments are provided to make this disclosure thorough and complete, and the concept of the embodiments of the present disclosure will be fully conveyed to those of ordinary skill in the art. In the following detailed description, various specific details are set forth by way of examples to provide a full understanding of the relevant teachings. However, it should be clear to those skilled in the art that the present teachings can be practiced without such details. In other instances, well-known methods, steps, and components have been described without going into detail to avoid unnecessarily obscuring aspects of the present teachings. The same reference numerals in the drawings represent the same elements, and thus descriptions thereof will not be repeated. In the drawings, the sizes and relative sizes of layers and areas may be exaggerated for clarity.

The present disclosure will now be described more fully hereinafter with reference to the accompanying drawings.

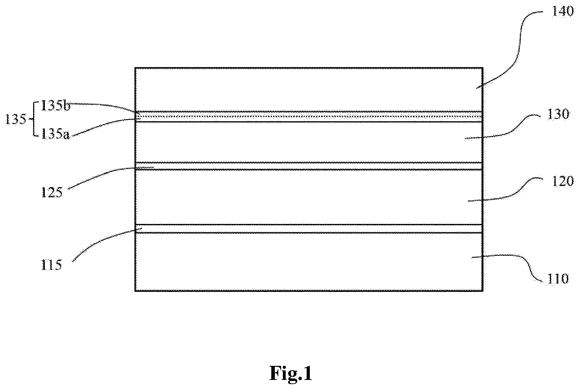

FIG. 1 shows a schematic diagram illustrating the structure of a composite monocrystalline film according to an embodiment of the present disclosure.

Referring to FIG. 1, a composite monocrystalline film according to an embodiment of the present disclosure may include: a substrate 110; a first transition layer 115 located on the substrate 110; a first isolation layer 120 located on the first transition layer 115; a second transition layer 125 located on the first isolation layer 120; the first film layer 130 located on the second transition layer 125; the third transition layer 135 located on the first film layer 130; and the second film layer 140 located on the third transition layer 135.

According to an embodiment of the present disclosure, the composite monocrystalline film may be prepared as a wafer which may have a diameter in a range from 2 to 12 in.

According to an embodiment of the present disclosure, the substrate 110 of the composite monocrystalline film may mainly play a supporting role. The substrate 110 according to an embodiment of the present disclosure may have a thickness in a range from 0.1 to 1 mm. Preferably, the thickness of the substrate 110 may range from 0.1 to 0.2 mm, from 0.3 to 0.5 mm, or from 0.2 to 0.5 mm.

According to an embodiment of the present disclosure, the first isolation layer 120 of the composite monocrystalline film is used to separate the substrate 110 from the first film layer 130. Since the substrate 110, such as the silicon substrate, has a larger refractive index than the lithium niobate or lithium tantalate monocrystalline film, and both materials have larger refractive indexes than silicon dioxide or silicon nitride, the first isolation layer 120 may be made of silicon dioxide or silicon nitride to separate the lithium niobate or lithium tantalate monocrystalline film from the substrate, thereby avoiding the case that the light field of the lithium niobate or lithium tantalate monocrystalline film is erroneously coupled into the substrate 110. According to an embodiment of the present disclosure, the first isolation layer 120 may be made of a material (for example, silicon dioxide or silicon nitride) which has a refractive index lower than that of the substrate 110 and the first film layer 130, but the present invention disclosure is not limited thereto. According to an embodiment of the present disclosure, the first isolation layer 120 may have a thickness in a range from 0.005 to 4 µm, and preferably, from 100 nm to 2 µm.

According to another embodiment of the present disclosure, the composite monocrystalline film may further include a second isolation layer (not shown) interposed between the first film layer 130 and the second film layer 140, and the second isolation layer may be a silicon dioxide layer or silicon nitride layer, and may have a thickness in a range from 0.005 to 4 µm, preferably, from 100 nm to 2 µm. But the present disclosure is not limited thereto. As the second isolation layer not only optically separates the first film layer 130 from the second film layer 140, but also prevents the mutual diffusion of elements between the first film layer 130 and the second film layer 140. The first film layer 130 and the second film layer 140 are protected from impurity contamination, and their quality are ensured so that their characteristics are not unaffected.

According to an embodiment of the present disclosure, the first isolation layer 120 and the second isolation layer may be formed on the substrate 110 and the first film layer 130 or the second film layer 140 by a method such as deposition or oxidation, respectively, but the present disclosure is not limited thereto.

According to an embodiment of the present disclosure, the composite monocrystalline film includes a first film layer 130 and a second film layer 140, which have different materials. The first film layer 130 is a lithium niobate or lithium tantalate monocrystalline film with excellent optical properties, and the second film layer 140 is a silicon monocrystalline film with excellent electrical properties. Each of the first film layer 130 and the second film layer 140 may have a nano-scale thickness in a range from 10 nm to 2000 nm. Preferably, the thicknesses of the first film layer 130 and the second film layer 140 may be in a range from 10 to 200 nm, from 300 to 900 nm, or from 1000 to 1500 nm. In addition, the upper surface of the second film layer 140 may be a polished surface or a rough surface which has a micron or sub-micron scale roughness.

According to an embodiment of the present disclosure, the composite monocrystalline film may include three transition layers, and each transition layer has its own characteristics.

According to an embodiment of the present disclosure, as shown in FIG. 1, the first transition layer 115 may be disposed between the substrate 110 and the first isolation layer 120, and have a thickness in a range from 0.5 to 15 nm.

According to an embodiment of the present disclosure, the first transition layer 115 may include elements inherent in the substrate 110 and the first isolation layer 120. In the first transition layer 115, the concentration of an element from the substrate 110 may gradually decrease from the substrate 110 toward the first isolation layer 120, and the concentration of an element from the first isolation layer 120 may gradually decrease from the first isolation layer 120 toward the substrate 110.

According to an embodiment of the present disclosure, the second transition layer 125 may be disposed between the first isolation layer 120 and the first film layer 130, and have a thickness in a range from 0.5 to 10 nm.

According to an embodiment of the present disclosure, the second transition layer 125 may include elements inherent in the first isolation layer 120 and the first film layer 130. In the second transition layer 125, the concentration of an element from the first isolation layer 120 may gradually decrease from the first isolation layer 120 toward the first film layer 130, and the concentration of an element from the first film layer 130 may gradually decrease from the first film layer 130 toward the first isolation layer 120.

According to an embodiment of the present disclosure, the third transition layer 135 may be disposed between the first film layer 130 and the second film layer 140, and have a thickness in a range from 0.5 to 15 nm.

In addition, according to an embodiment of the present disclosure, the third transition layer 135 may include a first sub-transition layer 135a adjacent to the first film layer 130 and a second sub-transition layer 135b adjacent to the second film layer 140. The first sub-transition layer 135a may have a thickness in a range from 0 to 5 nm, and the second sub-transition layer 135b may have a thickness in a range from 0 to 10 nm, but the embodiments of the present disclosure are not limited thereto. For example, the thicknesses of the first sub-transition layer 135a and the second sub-transition layer 135b may change as the temperature (e.g., the annealing temperature) in subsequent processes changes.

According to the embodiment of the present disclosure, the first sub-transition layer 135a mainly contains elements inherent in the first film layer 130. In the first sub-transition layer 135a, the concentration of an element from the first film layer 130 may gradually decrease from the first film layer 130 toward the second film layer 140. The second sub-transition layer 135b mainly contains elements inherent in the second film layer 140. In the second sub-transition layer 135b, the concentration of an element from the second film layer 140 may gradually decrease from the second film layer 140 toward the first film layer 130.

In addition, according to an embodiment of the present disclosure, when the first film layer 130 is a lithium niobate or lithium tantalate monocrystalline film and the second film layer 140 is a silicon monocrystalline film, the third transition layer 135 may include elements Si and Ta or Nb. In this case, the element Si is distributed across the third transition layer 135, that is, the element may be distributed across the first sub-transition layer 135a and the second sub-transition layer 135b, and the concentration of Si may gradually decrease from the second film layer 140 toward the first film layer 130. The element Ta or Nb may not be distributed across the third transition layer 135. For example, the element Ta or Nb exists only in the sub-transition layer (the first sub-transition layer 135a) adjacent to the first film layer 130, or a small amount of the element Ta or Nb exists in a portion thickness, which is close to the first film layer 130, of the sub-transition layer (i.e., the second sub-transition layer 135b) adjacent to the second film layer 140, and the concentration of the element Ta or Nb gradually decreases from the first film layer 130 toward the second film layer 140. However, the embodiments of the present disclosure are not limited thereto.

According to an embodiment of the present disclosure, the first transition layer 115, second transition layer 125, and third transition layer 135 further include elements H and Ar. The element Ar in the second transition layer 125 and third transition layer 135 is derived from the plasma used in the plasma bonding between the first isolation layer 120 and the first film layer 130 or between the first film layer 130 and the second film layer 140. As mentioned below, the element H in the first transition layer 115 is derived from the diffusion of the element H in the second transition layer 125 and third transition layer 135. The reason why the second transition layer 125 and third transition layer 135 have a higher concentration of element H is that when a surface of the first isolation layer 120, the first film layer 130 or the second film layer 140 is treated with plasma, the condition of the surface may be changed by the plasma bombardment on it, and a large number of active groups are formed thereon, so that the surface is provided with a higher activity. Therefore, when exposed to the air after the plasma treatment, the surface will absorb a large amount of water molecules in the air. After the bonding between the first isolation layer 120 and the first film layer 130 or between the first film layer 130 and the second film layer 140, a higher concentration of element H is present at the bonding interface. Furthermore, the element H in the first transition layer 115 is derived from the diffusion of the element H in the second transition layer 125 and third transition layer 135. In this case, the higher concentration of element H in the second transition layer 125 and third transition layer 135 may form hydrogen bonds to promote the bonding, and thus enhance the bonding force of the bonding interface between the first isolation layer 120 and the first film layer 130 or between the first film layer 130 and the second film layer 140.

According to an embodiment of the present disclosure, in the first transition layer 115, the concentrations of elements Ar and H gradually decrease from their maximum toward the substrate 110 and the first isolation layer 120, respectively. That is because the lattice constant of the surface is generally slightly larger than the lattice constant inside the material. In other words, the density of the material surface is less than the density inside the material, and the density of the interface (i.e., the first transition layer 115) between the substrate 110 and the first isolation layer 120 is less than the densities inside the substrate 110 and the first isolation layer 120, wherein the substrate 110 and the first isolation layer 120 contain different materials. That is, there are more voids to contain impurity atoms at the first transition layer 115, so that the concentrations of elements H and Ar in the transition layer may be higher than that inside the substrate 110 and the first isolation layer 120. In the second transition layer 125, the concentrations of elements Ar and H gradually decrease from their maximum toward the first isolation layer 120 and the first film layer 130. In the third transition layer 135, the concentrations of elements Ar and H gradually decrease from their maximum toward the first film layer 130 and the second film layer 140. In the first transition layer 115, second transition layer 125 and third transition layer 135, the concentration of the element H is in a range from 1 × 10¹⁹ to 1 × 10²² atoms/cc, and the concentration of the element Ar may be in a range from 1 × 10²⁰ to 1 × 10²³ atoms/cc, preferably, the concentration of the Ar element is in a range from 1 × 10²⁰ to 1 × 10²² atoms/cc, 1 × 10²¹ to 1 × 10²² atoms/cc, and 1 × 10²² to 1 × 10²³ atoms/cc.

A composite monocrystalline film according to an embodiment of the present disclosure includes a first transition layer 115, a second transition layer 125 and a third transition layer 135, which can disperse the stress between the monocrystalline films. Due to the stress dispersion, the monocrystalline film can have reduced defects and improved qualities, thereby reducing the transmission loss. Furthermore, the surfaces of the first transition layer 115, second transition layer 125 and third transition layer 135 are relatively flat, and the flat surfaces can reduce scattering in the propagation of signals and decrease the transmission loss.

The following examples illustrate the disclosure in more detail. However, these examples should not be construed as limiting the scope of the present disclosure in any sense.

### Preparation of a composite monocrystalline film

### Example 1: a composite monocrystalline film comprising silicon substrate/SiO₂ layer/lithium niobate monocrystalline film/silicon monocrystalline film

A monocrystalline silicon substrate wafer which has a size of 3 in, whereby 1 in = 25.4 mm, a thickness of 0.4 mm and has a smooth surface is prepared. After the silicon substrate is washed, a silicon dioxide layer with a thickness of 2 µm is formed on the smooth surface of the monocrystalline silicon substrate wafer by thermal oxidation.

A lithium niobate wafer with a size of 3 in is prepared. By using ion implantation, helium ions (He⁺) are implanted into the lithium niobate wafer at an implantation energy of 200 KeV and in a dose of 4 × 10¹⁶ ions/cm². A lithium niobate wafer having a three-layer structure which includes a film layer, a separation layer and an excess material layer is formed.

The film layer of the ion-implanted lithium niobate wafer is bonded to the silicon dioxide layer of the silicon substrate by plasma bonding to form a bonded body; and then, the bonded body is placed in a heating device at 350 °C for heat preservation until the residual material layer is separated from the bonded body to form a lithium niobate monocrystalline film. Thereafter, the lithium niobate monocrystalline film is polished and reduced to a thickness of 400 nm, and thus a lithium niobate monocrystalline film which has a nano-scale thickness is obtained.

A monocrystalline silicon wafer with a size of 3 in is prepared. By using ion implantation, hydrogen ions (H⁺) are implanted into the silicon wafer at an implantation energy of 40KeV and in a dose of 6 × 10¹⁶ ions/cm². A silicon wafer having a three-layer structure which includes a film layer, a separation layer and an excess material layer is formed.

The film layer of the ion-implanted silicon wafer is bonded to the above obtained lithium niobate monocrystalline film wafer by plasma bonding to obtain another bonded body. The bonded body is then placed in a heating device at 400 °C for heat preservation until the film layer of the silicon monocrystalline film wafer is separated from the bonded body, so that a composite structure which includes a silicon monocrystalline film as the top layer of the structure is formed, and the obtained composite structure is placed in an oven at 500 °C for heat preservation to remove the implantation damage. Finally, the silicon monocrystalline film is polished and reduced to a thickness of 220 nm, and thus a composite monocrystalline film product including two films which have a nano-scale thickness is obtained.

### Example 2: a composite monocrystalline film comprising silicon substrate/SiO₂ layer/lithium niobate monocrystalline film/SiO₂ layer/silicon monocrystalline film

A monocrystalline silicon wafer which has a size of 3 in, a thickness of 0.4 mm and has a smooth surface is prepared as a substrate. After the substrate wafer is washed, a silicon dioxide layer with a thickness of 2.5 µm is formed on the smooth surface of the substrate wafer by thermal oxidation.

A lithium niobate wafer with a size of 3 in is prepared. By using ion implantation, helium ions (He²⁺) are implanted into the lithium niobate wafer at an implantation energy of 200 KeV and in a dose of 4 × 10¹⁶ ions/cm². A lithium niobate wafer having a three-layer structure which includes a film layer, a separation layer and an excess material layer is formed.

The film layer of the ion-implanted lithium niobate wafer is bonded to the silicon dioxide layer of the silicon substrate by plasma bonding to form a bonded body. The bonded body is then placed in a heating device at 350 °C for heat preservation until the residual material layer is separated from the bonded body to form a lithium niobate monocrystalline film. Thereafter, the lithium niobate monocrystalline film is polished and reduced to a thickness of 300 nm, and a bonded body including a lithium niobate monocrystalline film which has a nano-scale thickness is obtained.

A monocrystalline silicon wafer which has a size of 3 in and a surface covered by a SiO₂ layer (50 nm in thickness) is prepared. By using ion implantation, hydrogen ions (H⁺) are implanted into the silicon wafer covered by SiO₂ at an implantation energy of 40KeV and in a dose of 6 × 10¹⁶ ions/cm². A silicon wafer having a three-layer structure which includes a film layer, a separation layer and an excess material layer is formed.

The film layer of the ion-implanted silicon wafer is bonded to the above obtained lithium niobate monocrystalline film by plasma bonding to obtain another bonded body; and then the bonded body is placed in a heating device at 400 °C for heat preservation until the excess material layer of the silicon wafer is separated from the bonded body, so that a composite structure which includes a silicon monocrystalline film as the top layer of the structure is formed, and the obtained composite structure is placed in an oven at 600 °C for heat preservation to remove the implantation damage. Finally, the silicon monocrystalline film is polished and reduced to a thickness of 220 nm, and thus a composite monocrystalline film product including two films which have a nano-scale thickness is obtained.

### Example 3: a composite monocrystalline film comprising silicon substrate/SiO₂ layer/lithium tantalate monocrystalline film/silicon monocrystalline film

A monocrystalline silicon substrate wafer which has a size of 3 in, a thickness of 0.4 mm and has a smooth surface is prepared. After the substrate wafer is washed, a silicon dioxide layer with a thickness of 600 nm is formed on the smooth surface of the substrate wafer by using thermal oxidation.

A lithium tantalate monocrystalline film wafer with a size of 3 in is prepared. By using ion implantation, helium ions (He⁺) are implanted into the lithium tantalate wafer at an implantation energy of 200 KeV and in a dose of 4 × 10¹⁶ ions/cm². A lithium tantalate wafer having a three-layer structure which includes a film layer, a separation layer and an excess material layer is formed.

The film layer of the ion-implanted lithium tantalate wafer is bonded to the silicon dioxide layer of the silicon substrate wafer by plasma bonding to form a bonded body; and then the bonded body is placed in a heating device at 350 °C for heat preservation, until the residual material layer is separated from the bonded body to form a lithium tantalate monocrystalline film. Thereafter, the lithium tantalate monocrystalline film is polished and reduced to a thickness of 400 nm, and thus a bonded body including the lithium tantalate monocrystalline film which has a nano-scale thickness is obtained.

A monocrystalline silicon wafer with a size of 3 in is prepared. By using ion implantation, hydrogen ions (H⁺) are implanted into the silicon wafer at an implantation energy of 80KeV and in a dose of 6 × 10¹⁶ ions/cm². A silicon wafer having a three-layer structure which includes a film layer, a separation layer and an excess material layer is formed.

The film layer of the silicon wafer is bonded to the above obtained lithium tantalate monocrystalline film by plasma bonding to obtain another bonded body; and then the bonded body is placed in a heating device at 400 °C for heat preservation until the excess material layer of the silicon wafer is separated from the bonded body, so that a composite structure which includes a silicon monocrystalline film as the top layer of the structure is formed, and the obtained composite structure is placed in an oven at 500 °C for heat preservation to remove the implantation damage. Finally, the silicon monocrystalline film is polished and reduced to a thickness of 500 nm, and thus a composite monocrystalline film product including two films which have a nano-scale thickness is obtained.

### Example 4: a composite monocrystalline film comprising lithium tantalate substrate/SiO₂ layer/lithium tantalate monocrystalline film/silicon monocrystalline film

A lithium tantalate substrate wafer which has a size of 3 in, a thickness of 0.4 mm and has a smooth surface is prepared. After the substrate wafer is washed, a silicon dioxide layer with a thickness of 1.0 µm is deposited on the smooth surface of the substrate wafer by a deposition method, and the substrate wafer deposited with silicon dioxide layer is annealed; and then the silicon dioxide layer is polished to a target thickness of 600 nm.

A lithium tantalate wafer with a size of 3 in is prepared. By using ion implantation, helium ions (He²⁺) are implanted into the lithium tantalate wafer at an implantation energy of 400 KeV and in a dose of 4 × 10¹⁶ ions/cm². A lithium tantalate wafer having a three-layer structure which includes a film layer, a separation layer and an excess material layer is formed.

The film layer of the ion-implanted lithium tantalate wafer is bonded to the silicon dioxide layer of the silicon substrate wafer deposited with the silicon dioxide layer by plasma bonding to form a bonded body; and then the bonded body is placed in a heating device at 350 °C for heat preservation until the residual material layer is separated from the bonded body to form a lithium tantalate monocrystalline film. Thereafter, the lithium tantalate monocrystalline film is polished and reduced to a thickness of 800 nm, and a lithium tantalate monocrystalline film which has a nano-scale thickness is obtained.

A monocrystalline silicon wafer with a size of 3 in is prepared. By using ion implantation, hydrogen ions (H⁺) are implanted into the silicon wafer at an implantation energy of 80KeV and in a dose of 6 × 10¹⁶ ions/cm². A silicon wafer having a three-layer structure which includes a film layer, a separation layer and an excess material layer is formed.

The film layer of the ions-implanted silicon wafer is bonded to the above obtained lithium tantalate monocrystalline film by plasma bonding to obtain another bonded body; and then the bonded body is placed in a heating device at 400 °C for heat preservation until the excess material layer of the silicon wafer is separated from the bonded body, so that a composite structure which includes a silicon monocrystalline film as the top layer of the structure is formed. Thereafter, the silicon monocrystalline film is polished and reduced to a thickness of 500 nm, and thus a composite monocrystalline film product including two films which have a nano-scale thickness is obtained. Finally, the composite monocrystalline film product is placed in an oven at 500 °C for heat preservation to remove the implantation damage.

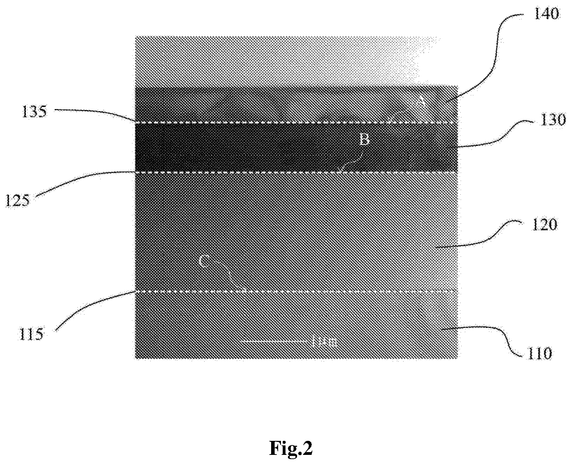

FIG. 2 illustrates a TEM image of the composite monocrystalline film according to Example 1 of the present disclosure.

Referring to FIG. 2, in a composite monocrystalline film according to an embodiment of the present disclosure, the substrate 110 is a silicon substrate, the first isolation layer 120 is a silicon dioxide layer, the first film layer 130 is a lithium niobate monocrystalline film, and the second film layer 140 is a silicon monocrystalline film. As can be seen from FIG. 2, the composite monocrystalline film according to an embodiment of the present disclosure includes a first transition layer 115 interposed between the substrate 110 and the first isolation layer 120, a second transition layer 125 interposed between the first isolation layer 120 and the first film layer 130, and a third transition layer 135 interposed between the first film layer 130 and the second film layer 140. According to an embodiment of the present disclosure, the bonding interface in the composite monocrystalline film is clear and the boundary line is relatively flat, so the loss of the acoustic wave and the light wave at the interfaces is greatly reduced, thereby improving the device performance.

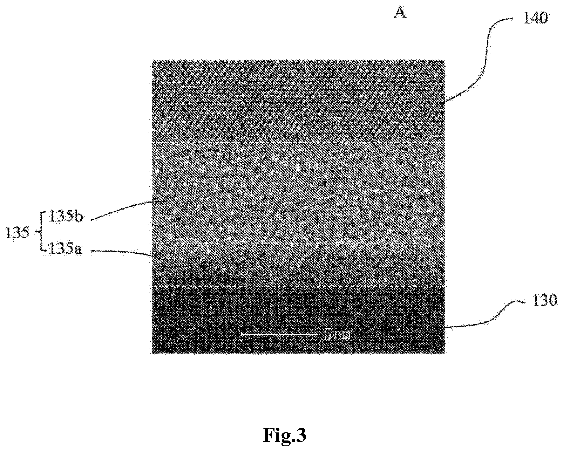

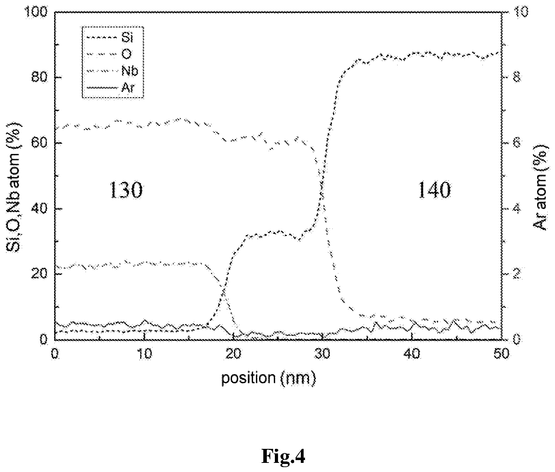

FIG. 3 shows an enlarged view of the area A shown in FIG. 2, and FIG. 4 shows an element distribution diagram of the area A shown in FIG. 2.

Referring to FIG. 3, the area A located between the first film layer 130 and the second film layer 140 of the composite monocrystalline film includes four layers with clear interfaces, i.e., the first film layer 130, the third transition layer 135 including a first sub-transition layer 135a and a second sub-transition layer 135b, and the second film layer 140. The first sub-transition layer 135a is adjacent to the first film layer 130, and the second sub-transition layer 135b is adjacent to the second film layer 140 and disposed on the first sub-transition layer 135a. The thicknesses of the first sub-transition layer 135a and the second sub-transition layer 135b are related to the annealing temperature of the composite monocrystalline film.

Referring to FIG. 4, in the interface area A between the first film layer 130 and the second film layer 140 of the composite monocrystalline film, whereby the first film layer 130 is a lithium niobate monocrystalline film and the second film layer 140 is a silicon monocrystalline film, element Si has a maximum concentration in the second film layer 140, its concentration gradually increases from the first film layer 130 toward the second film layer 140, and element Si is distributed across the third transition layer 135. Elements Nb and O have maximum concentrations in the first film layer 130, their concentrations gradually increase from the second film layer 140 toward the first film layer 130, and element Nb is not distributed across the third transition layer 135. In addition, a small amount of element Ar is present in the third transition layer 135.

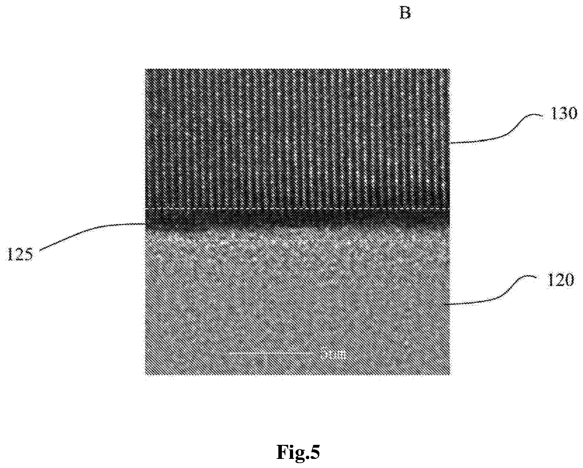

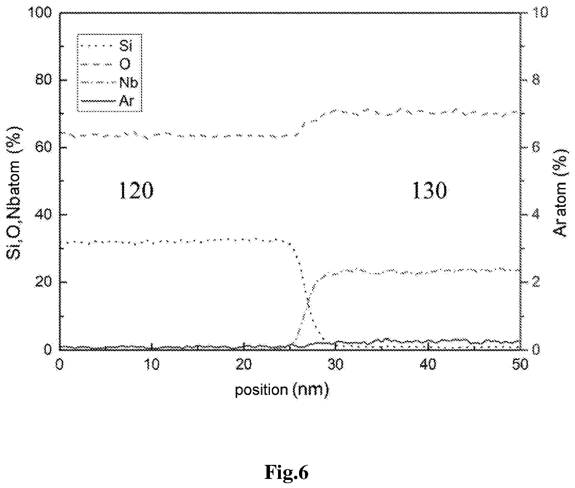

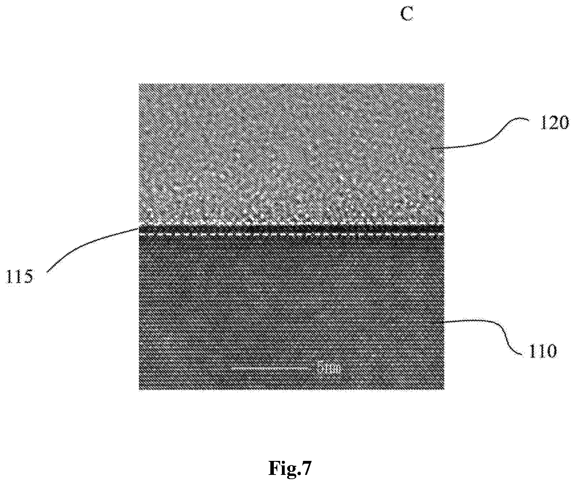

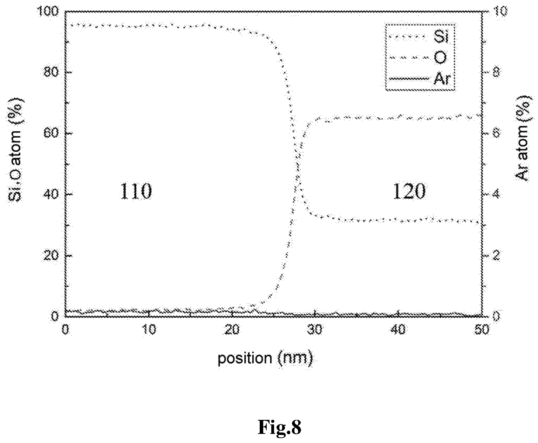

FIGS. 5 and 7 shows enlarged views of areas B and C shown in FIG. 2, respectively, and FIGS. 6 and 8 shows element distribution diagrams of areas B and C shown in FIG. 2, respectively.

Referring to FIGS. 5 and 7, there are very thin transition layers which have clear and flat interfaces between the first isolation layer 120 and the first film layer 130 and between the substrate 110 and the first isolation layer 120, i.e., the second transition layer 125 interposed between the isolation layer 120 and the first film layer 130 and the first transition layer 115 interposed between the substrate 110 and the first isolation layer 120.

Referring to FIG. 6, in a case where the first film layer 130 is a lithium niobate monocrystalline film and the first isolation layer 120 is a silicon dioxide layer, in the second transition layer 125 between the first isolation layer 120 and the first film layer 130, element Si has a maximum concentration in the first isolation layer 120, and its concentration gradually decreases from the first isolation layer 120 toward the first film layer 130. Element Nb has a maximum concentration in the first film layer 130, and its concentration gradually decreases from the first film layer 130 toward the first isolation layer 120. In addition, the second transition layer 125 also contains a higher concentration of element O and a small amount of element Ar.

Referring to FIG. 8, in a case where the first isolation layer 120 is a silicon dioxide layer and the substrate 110 is a silicon substrate, in the first transition layer 115 between the first isolation layer 120 and the substrate 110, element O has a maximum concentration in the first isolation layer 120, and its concentration gradually decreases from the first isolation layer 120 toward the substrate 110. Element Si has a maximum concentration in the substrate 110, and its concentration gradually decreases from the substrate 110 toward the first isolation layer 120. In addition, the first transition layer 115 further contains a small amount of Ar element.

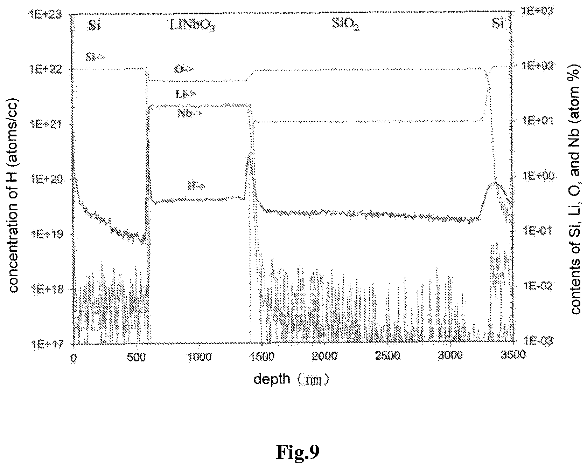

FIG. 9 illustrates a SIMS image of the areas A and B shown in FIG. 2.

Referring to FIG. 9, a high concentration of element H is contained in the second transition layer 125 and the third transition layer 135, and the concentration of the element H is in a range from 1 × 10²⁰ to 1 × 10²¹ atoms/cc. The concentration of H in the second transition layer 125 may be higher than that in the first isolation layer 120 and first film layer 130, and the concentration of H in the third transition layer 135 may be higher than that in the first film layer 130 and second film layer 140. The high concentration of H element enhances the bonding force of the bonding interfaces.

The present disclosure provides a composite monocrystalline film that combines the excellent optical properties of a lithium niobate or lithium tantalate monocrystalline film with the excellent electrical properties of a silicon material, and thus provides an improved performance. Moreover, the composite monocrystalline film includes a transition layer with relatively flat surfaces, which can disperse the stress between the monocrystalline films and reduce scattering in the propagation of signals. The monocrystalline films can have reduced defects and improved quality, and thus reducing the transmission loss.

Although the present disclosure has been particularly illustrated and described with reference to exemplary embodiments thereof, those of ordinary skill in the art will understand various changes in form and detail can be made accordingly without departing from the scope of the present disclosure as defined by the appended claims.

## Claims

1. A composite monocrystalline film, comprising:
a substrate (110);
a first isolation layer (120) disposed on the substrate;
a first film layer ((130) disposed on the first isolation layer; and
a second film layer (140) disposed on the first film layer,
wherein the first film layer is a lithium niobate or lithium tantalate monocrystalline film layer, and the second film layer is a silicon monocrystalline film layer,
wherein a first transition layer (115) is formed between the substrate and the first isolation layer, a second transition (125) layer is formed between the first isolation layer and the first film layer and a third transition (135) layer is formed between the first film layer and the second film layer,
wherein, the first transition layer, second transition layer and third transition layer include elements H and Ar,
the Ar element in the second transition layer (125) and third transition layer (135) is derived from a plasma used in the plasma bonding between the first isolation layer (120) and the first film layer (130) or between the first film layer (130) and the second film layer 140, the element H in the first transition layer (115) is derived from the diffusion of the element H in the second transition layer (125) and third transition layer (135);
wherein the concentration of H in the first transition layer, second transition layer and third transition layer ranges from 1 × 10¹⁹ to 1 × 10²² atoms/cc.

2. The composite monocrystalline film according to claim 1, wherein the composite monocrystalline film further comprises a second isolation layer interposed between the first film layer and the second film layer, and each of the first isolation layer and the second isolation layer is a silicon dioxide layer or silicon nitride layer and has a thickness of 0.005 µm to 4 µm.

3. The composite monocrystalline film according to claim 1, wherein the concentration of the element Ar in the first transition layer, second transition layer and third transition layer ranges from 1 × 10²⁰ to 1 × 10²³ atoms/cc.

4. The composite monocrystalline film according to claim 1, wherein the concentration of H in the second transition layer is higher than that in the first isolation layer and the first film layer, and the concentration of H in the third transition layer is higher than that in the first film layer and the second film layer.

5. The composite monocrystalline film according to claim 1, wherein the first transition layer has a thickness of 0.5 to 15 nm, the second transition layer has a thickness of 0.5 to 10 nm, and the third transition layer has a thickness of 0.5 to 15nm.

6. The composite monocrystalline film according to claim 1, wherein the third transition layer includes a first sub-transition layer (135a) adjacent to the first film layer and a second sub-transition layer (135b) adjacent to the second film layer, wherein, in the first sub-transition layer, the concentration of an element from the first film layer is higher the concentration of an element from the second film layer, and the concentration of the element from the first film layer gradually decreases from the first sub-transition layer toward the second sub-transition layer, in the second sub-transition layer, the concentration of an element from the second film layer is higher than the concentration of an element from the first film layer, and the concentration of the element from the second film layer gradually decreases from the second sub-transition layer toward the first sub-transition layer.

7. The composite monocrystalline film according to claim 1, wherein each of the first film layer and the second film layer is a monocrystalline film which has a nano-scale thickness of 10 to 2000 nm.

8. The composite monocrystalline film according to claim 1 wherein the third transition layer includes:
Si, which is distributed across the third transition layer, wherein the concentration of Si gradually decreases from the silicon monocrystalline film layer toward the lithium niobate or lithium tantalate monocrystalline film layer;
Ta or Nb, which is not distributed across the third transition layer, wherein the concentration of Ta or Nb gradually decreases from the lithium niobate or lithium tantalate monocrystalline film layer toward the silicon monocrystalline film layer.

9. The composite monocrystalline film according to claim 1 or 2, wherein the substrate is a silicon substrate, lithium niobate substrate or lithium tantalate substrate, and the substrate has a thickness of 0.1 to 1 mm.

## Patentansprüche

1. Monokristalliner Verbundfilm, umfassend:
ein Substrat (110);
eine erste Isolierschicht (120), die auf dem Substrat angeordnet ist;
eine erste Filmschicht (130), die auf der ersten Isolierschicht angeordnet ist; und
eine zweite Filmschicht (140), die auf der ersten Filmschicht angeordnet ist,
wobei die erste Filmschicht eine einkristalline Lithiumniobat- oder Lithiumtantalat-Filmschicht ist und die zweite Filmschicht eine einkristalline Silizium-Filmschicht ist,
wobei eine erste Übergangsschicht (115) zwischen dem Substrat und der ersten Isolationsschicht, eine zweite Übergangsschicht (125) zwischen der ersten Isolationsschicht und der ersten Filmschicht und eine dritte Übergangsschicht (135) zwischen der ersten Filmschicht und der zweiten Filmschicht gebildet wird,
wobei die erste Übergangsschicht, die zweite Übergangsschicht und die dritte Übergangsschicht die Elemente H und Ar enthalten, das Element Ar in der zweiten Übergangsschicht (125) und der dritten Übergangsschicht (135) aus einem Plasma stammt, das bei der Plasmabindung zwischen der ersten Isolationsschicht (120) und der ersten Filmschicht (130) oder zwischen der ersten Filmschicht (130) und der zweiten Filmschicht (140) verwendet wird, das Element H in der ersten Übergangsschicht (115) aus der Diffusion des Elementes H in der zweiten Übergangsschicht (125) und der dritten Übergangsschicht (135) stammt;
wobei die Konzentration von H in der ersten Übergangsschicht, der zweiten Übergangsschicht und der dritten Übergangsschicht im Bereich von 1 × 10¹⁹ bis 1 × 10²² Atome/cm³ liegt.

2. Monokristalliner Verbundfilm nach Anspruch 1, wobei der monokristalline Verbundfilm ferner eine zweite Isolationsschicht umfasst, die zwischen der ersten Filmschicht und der zweiten Filmschicht angeordnet ist, und sowohl die erste Isolationsschicht als auch die zweite Isolationsschicht eine Siliziumdioxidschicht oder Siliziumnitridschicht ist und eine Dicke von 0,005 µm bis 4 µm aufweist.

3. Monokristalliner Verbundfilm nach Anspruch 1, wobei die Konzentration des Elementes Ar in der ersten Übergangsschicht, der zweiten Übergangsschicht und der dritten Übergangsschicht im Bereich von 1 × 10²⁰ bis 1 × 10²³ Atome/cm³ liegt.

4. Monokristalliner Verbundfilm nach Anspruch 1, wobei die Konzentration von H in der zweiten Übergangsschicht höher ist als die in der ersten Isolationsschicht und der ersten Filmschicht, und die Konzentration von H in der dritten Übergangsschicht höher ist als die in der ersten Filmschicht und der zweiten Filmschicht.

5. Monokristalliner Verbundfilm nach Anspruch 1, wobei die erste Übergangsschicht eine Dicke von 0,5 bis 15 nm hat, die zweite Übergangsschicht eine Dicke von 0,5 bis 10 nm und die dritte Übergangsschicht eine Dicke von 0,5 bis 15 nm aufweist.

6. Monokristalliner Verbundfilm nach Anspruch 1, wobei die dritte Übergangsschicht eine erste Teilübergangsschicht (135a) angrenzend an die erste Filmschicht und eine zweite Teilübergangsschicht (135b) angrenzend an die zweite Filmschicht aufweist, wobei in der ersten Teilübergangsschicht die Konzentration eines Elementes aus der ersten Filmschicht höher ist als die Konzentration eines Elementes aus der zweiten Filmschicht, und die Konzentration des Elementes aus der ersten Filmschicht allmählich von der ersten Teilübergangsschicht zur zweiten Teilübergangsschicht abnimmt, in der zweiten Teilübergangsschicht die Konzentration eines Elementes aus der zweiten Filmschicht höher ist als die Konzentration eines Elementes aus der ersten Filmschicht und die Konzentration des Elementes aus der zweiten Filmschicht allmählich von der zweiten Teilübergangsschicht zur ersten Teilübergangsschicht abnimmt.

7. Monokristalliner Verbundfilm nach Anspruch 1, wobei die erste Filmschicht und die zweite Filmschicht jeweils ein monokristalliner Film mit einer Dicke im Nanobereich von 10 bis 2000 nm ist.

8. Monokristalliner Verbundfilm nach Anspruch 1, wobei die dritte Übergangsschicht enthält:
Si, das über die dritte Übergangsschicht verteilt ist, wobei die Si-Konzentration von der monokristallinen Siliziumfilmschicht allmählich in Richtung der monokristallinen Lithiumniobat- oder Lithiumtantalat-Filmschicht abnimmt;
Ta oder Nb, die nicht über die dritte Übergangsschicht verteilt sind, wobei die Konzentration von Ta oder Nb allmählich von der monokristallinen Lithiumniobat- oder Lithiumtantalat-Filmschicht zur monokristallinen Silizium-Filmschicht abnimmt.

9. Monokristalliner Verbundfilm nach Anspruch 1 oder 2, wobei das Substrat ein Siliziumsubstrat, Lithiumniobat-Substrat oder Lithiumtantalat-Substrat ist und das Substrat eine Dicke von 0,1 bis 1 mm aufweist.

## Revendications

1. Film monocristallin composite, comprenant :
un substrat (110) ;
une première couche d'isolation (120) disposée sur le substrat ;
une première couche de film (130) disposée sur la première couche d'isolation ; et
une deuxième couche de film (140) disposée sur la première couche de film,
dans lequel la première couche de film est une couche de film monocristallin de niobate de lithium ou de tantalate de lithium, et la deuxième couche de film est une couche de film monocristallin de silicium,
dans lequel une première couche de transition (115) est formée entre le substrat et la première couche d'isolation, une deuxième couche de transition (125) est formée entre la première couche d'isolation et la première couche de film et une troisième couche de transition (135) est formée entre la première couche de film et la deuxième couche de film,
dans lequel la première couche de transition, la deuxième couche de transition et la troisième couche de transition comprennent les éléments H et Ar,
l'élément Ar dans la deuxième couche de transition (125) et la troisième couche de transition (135) provient d'un plasma utilisé dans la liaison plasma entre la première couche d'isolation (120) et la première couche de film (130) ou entre la première couche de film (130) et la deuxième couche de film 140, l'élément H dans la première couche de transition (115) provient de la diffusion de l'élément H dans la deuxième couche de transition (125) et la troisième couche de transition (135) ;
dans lequel la concentration de H dans la première couche de transition, la deuxième couche de transition et la troisième couche de transition est comprise entre 1 × 10¹⁹ et 1 × 10²² atomes/cm³.

2. Film monocristallin composite selon la revendication 1, dans lequel le film monocristallin composite comprend en outre une deuxième couche d'isolation interposée entre la première couche de film et la deuxième couche de film, et chacune de la première couche d'isolation et de la deuxième couche d'isolation est une couche de dioxyde de silicium ou une couche de nitrure de silicium et a une épaisseur allant de 0,005 um à 4 µm.

3. Film monocristallin composite selon la revendication 1, dans lequel la concentration de l'élément Ar dans la première couche de transition, la deuxième couche de transition et la troisième couche de transition est comprise entre 1 × 10²⁰ et 1 × 10²³ atomes/cm³.

4. Film monocristallin composite selon la revendication 1, dans lequel la concentration de l'élément H dans la deuxième couche de transition est supérieure à celle de la première couche d'isolation et de la première couche de film, et la concentration de l'élément H dans la troisième couche de transition est supérieure à celle de la première couche de film et de la deuxième couche de film.

5. Film monocristallin composite selon la revendication 1, dans lequel la première couche de transition a une épaisseur allant de 0,5 à 15 nm, la deuxième couche de transition a une épaisseur allant de 0,5 à 10 nm, et la troisième couche de transition a une épaisseur allant de 0,5 à 15 nm.

6. Film monocristallin composite selon la revendication 1, dans lequel la troisième couche de transition comprend une première couche de sous-transition (135a) adjacente à la première couche de film et une deuxième couche de sous-transition (135b) adjacente à la deuxième couche de film,
dans lequel, dans la première couche de sous-transition, la concentration d'un élément de la première couche de film est supérieure à la concentration d'un élément de la deuxième couche de film, et la concentration de l'élément de la première couche de film diminue progressivement de la première couche de sous-transition vers la deuxième couche de sous-transition, dans la deuxième couche de sous-transition, la concentration d'un élément de la deuxième couche de film est supérieure à la concentration d'un élément de la première couche de film, et la concentration de l'élément de la deuxième couche de film diminue progressivement de la deuxième couche de sous-transition vers la première couche de sous-transition.

7. Film monocristallin composite selon la revendication 1, dans lequel la première couche de film et la deuxième couche de film sont des films monocristallins dont l'épaisseur à l'échelle nanométrique est comprise entre 10 et 2 000 nm.

8. Film monocristallin composite selon la revendication 1, dans lequel la troisième couche de transition comprend :
l'élément Si, qui est distribué à travers la troisième couche de transition, dans lequel la concentration de l'élément Si diminue progressivement de la couche de film monocristallin de silicium vers la couche de film monocristallin de niobate de lithium ou de tantalate de lithium ;
l'élément Ta ou l'élément Nb, qui n'est pas réparti sur la troisième couche de transition, dans lequel la concentration de l'élément Ta ou de l'élément Nb diminue progressivement de la couche de film monocristallin de niobate de lithium ou de tantalate de lithium vers la couche de film monocristallin de silicium.

9. Film monocristallin composite selon la revendication 1 ou la revendication 2, dans lequel le substrat est un substrat de silicium, un substrat de niobate de lithium ou un substrat de tantalate de lithium, et le substrat a une épaisseur allant de 0,1 à 1 mm.
